# EUROPEAN PATENT SPECIFICATION

(11) **EP 2 265 747 B1**
(45) Date of publication and mention of the grant of the patent: **21.12.2016**
(21) Application number: 09722758.1
(22) Date of filing: 10.02.2009
(51) Int. Cl.: C23C 18/54, C23C 18/16, C23C 18/24, C23C 18/31, H05K 3/18, H05K 1/03

(54) **PROCESS FOR PREVENTING PLATING ON A PORTION OF A MOLDED PLASTIC PART**
VERFAHREN ZUR VERHINDERUNG VON METALLABSCHEIDUNG AUF EINEM TEIL EINES KUNSTSTOFF-FORMTEILS
PROCÉDÉ POUR PRÉVENIR LE DÉPÔT SUR UNE PARTIE D' UNE PIÈCE EN PLASTIQUE MOULÉ

(30) Priority: 18.03.2008 US 50709
(43) Date of publication of application: 29.12.2010
(73) Proprietor: MacDermid, Incorporated, Waterbury, CT 06702 (US)
(72) Inventor: WOJTASZEK, Mark, Canton CT 06019 (US); HAMILTON, Robert, Torrington CT 06790 (US)
(74) Representative: Jenkins, Peter David
(86) International application number: PCT/US2009/033641
(87) International publication number: WO 2009/117187

(56) References cited:
- DE-A1- 19 606 636
- GB-A- 1 555 709
- US-A- 3 443 988
- US-A- 4 293 592
- US-A- 5 167 992
- US-A- 5 407 622
- US-A- 5 648 125
- US-A1- 2006 258 228
- US-B2- 6 740 425

## Description

### FIELD OF THE INVENTION

The present invention relates to an improved method of selectively plating a molded plastic article.

### BACKGROUND OF THE INVENTION

Molded-one piece articles are used, for example in forming printed circuit and wiring boards. In many instances, two separate molding steps are used to form two portions of the article. For example, two-shot molding is a means of producing devices having two portions, such as molded interconnect devices (including printed circuit boards), from a combination of two injection molded polymers. The process is also used for producing two-colored molded plastic articles and for combining hard and soft plastics in one molded part.

A typical two-shot molding process includes the following steps:
- 1.: Mold first shot;
- 2.: Overmold first shot with second polymer;
- 3.: Etch and activate exposed areas; and
- 4.: Plate with electroless nickel or electroless copper to deposit plating material.

In addition to possessing the required end use properties of the product, the two polymers selected for use must be compatible in the two-shot molding process and must also provide a suitable combination for plating. In order to plate one of the polymers and not the other, it is generally been found necessary to either selectively activate the polymer to be plated after the molding process or to use a polymer having a catalyst disposed therein, i.e., a polymer containing a certain percentage of palladium, as described for example in U.S. Patent No. 7,189,120 to Zaderej. Other two-shot (or multishot) molding processes are described in U.S. Patent No. 5,407,622 to Cleveland et al. and in U.S. Patent No. 6,601,296 to Dailey et al.

However, these processes can still allow extraneous plating of at least part of the non-plateable polymer, especially at locations adjacent to where the two polymers meet, which can affect the performance of the molded interconnect device. Thus, it would be desirable to develop a process of two-shot injection molding that provides for a clearer line of demarcation between the plateable portion and the non-plateable portion of the molded interconnect device.

The present invention relates generally to molded articles having a first portion that is receptive to electroless plating thereon and a second portion which substantially inhibits electroless plating thereon. More particularly, the present invention relates to molded blanks for printed circuit boards and molded articles, and processes for forming the blanks and plating portions of the articles which include two separate molding steps to form portions of the articles.

US-A-4,293,592 discloses a method for production of printed circuits by electroless metal plating. US-A-3,443,988 discloses printed circuits, work holders and a method of preventing electroless metal deposition. DE 196 06 636 A discloses a resist composition for electroless plating of printed circuit boards.

### SUMMARY OF THE INVENTION

It is an object of the present invention to form a molded article for adherent metallization, such as a printed circuit board with a circuit pattern, by a two shot injection molding process, wherein the first shot forms the circuit pattern and the second shot forms a support structure around the circuit pattern.

It is another object of the present invention to form a molded article for selective metallization to provide a clear line of demarcation between the plateable portion and the non-plateable portion of the molded article.

It is still another object of the present invention to provide a process for selective metallization of a molded article that minimizes or eliminates metal adherence to the non-plateable portion of the molded article.

To that end, the present invention relates generally to a selectively plated article according to claim 1, comprising:
a) a first plastic portion comprising a catalytic poison uniformly dispersed therein that inhibits electroless plating on the first plastic portion; and
b) a second plastic portion that is receptive to electroless plating thereon and having a layer of electroless metal plating deposited thereon;
wherein the first plastic portion is free of electroless metal plate; characterized in that the catalytic poison is iodobenzoic acid.

The present invention also relates generally to a method according to claim 3 of plating a plastic part, the method comprising the steps of:
a) providing a plastic part comprising:
   i) a first plastic portion comprising a first plastic and a catalytic poison uniformly dispersed in the first plastic that inhibits electroless plating on the first plastic portion; and
   ii) a second plastic portion comprising a second plastic that is receptive to electroless plating thereon;
b) preparing the plastic part to accept elecroless plating on the second plastic portion that is receptive to electroless plating; and
c) plating the plastic part in an electroless plating bath;
whereby the first plastic portion is free of electroless plating; characterized in that the catalytic poison is iodobenzoic acid.

Preferred features are defined in the dependent claims.

### DETAILED DESCRIPTION OF THE PREFERRED EMBODIMENTS

A dual-shot injection molding process, as discussed above, forms first and second "shots" respectively from one and then the other of a non-plateable polymer and a plateable polymer that together comprise the plastic part. The two portions are forced, under pressure into a closed mold or molds and the materials solidify within the mold cavity. The molded material retains the shape of the mold, and the finished molded part is then ejected from the mold cavity.

In order to prevent any electroless metal from plating onto the non-plateable portions, the present invention relates to a method of incorporating a catalytic poison into a portion of the double-shot molded plastic part, to retard the tendency of subsequently applied electroless plating chemistry to create a plated deposit on that portion containing the catalytic poison compound. The double shot molded plastic part can then be processed through a standard plating-on-plastic process line that utilizes a chromic acid/sulfuric acid etch or alkaline permanganate solution, a neutralizer, colloidal activation, acceleration, and then subjected to electroless copper or electroless nickel plating chemistry. Other plating-on-plastic processes known in the art may also be used in the practice of the invention. In the alternative, the plastic or resin to be plated on can have a plating catalyst, such as palladium, incorporated into the resin and the plastic or resin portion to be free from plate can have the catalytic or plating poison incorporated into it. Thus what is important is that the plastic or resin which in intended to be free from plate has the catalytic or plating poison and that the other portion of the article not have the catalytion plating poison. This allows for either the entire article to be activated or for only portions to be activated, but in either case the areas with the catalytic or plating poison will not be plated (even if activated).

After being processed through the steps of the plating-on-plastic line, only one portion of the molded part becomes receptive to electroless plating while the other portion does not. The innovative process described herein also eliminates electroless copper and electroless nickel plating chemistries from cross boundary interfaces throughout the part and creating extraneous plate across two different resin types.

The present invention incorporates a catalytic poison into specific portions of the double shot resin matrix. The result is a molded plastic part that exhibits improved plating quality and reduced plating scrap and also solves a plaguing industry problem regarding extraneous plating of double shot molded pieces. The catalytic poison must be compatible with the polymer matrix such that the catalytic poison can be uniformly distributed in the polymer matrix.

The catalytic poison is chosen so as to be compatible with the polymer matrix of the first plastic portion and to allow uniform distribution of the catalytic poison therein. The catalytic poison also acts as a surface concentration maximization agent after etching/neutralization. Finally, the catalytic poison is not affected by the etching and neutralization steps other than to achieve surface concentration maximization. One of the benefits of the present invention is that there is a clean line of demarcation between the plated portion of the substrate and the non-plated portion of the substrate that is not observed in processes of the prior art.

In one embodiment, the plating portion has a palladium catalyst dispersed therein.

In the articles and methods of the present invention, the catalytic poison is iodobenzoic acid.

In one embodiment, the process of the invention relates to a method of plating a plastic part, the method comprising the steps of:
a) providing a plastic part comprising (i) a first plastic portion comprising a first plastic and a catalytic poison uniformly dispersed in the first plastic that inhibits electroless plating on the first plastic portion and (ii) a second plastic portion comprising a second plastic that is receptive to electroless plating thereon;
b) preparing the plastic part to accept elecroless plating on the second plastic portion that is receptive to electroless plating; and
c) plating the plastic part in an electroless plating bath;
whereby the first plastic portion is free of electroless plating, and wherein the catalytic poison is iodobenzoic acid.

The amount of catalytic poison to be added to the first plastic portion to prevent plating is dependent in part on the catalytic poison that is used as well as the particular plastic that is being used. The amount of catalytic poison can be determined by adding the poison incrementally to the plastic portion until plating stops. The amount of catalytic poison is measured based on the sulfur content of the catalytic poison. The concentration of catalytic poison, measured as sulfur, is typically at least about **0.015** mg/, more preferably about **0.025** mg/L to about **2.5** mg/L, and most preferably about **0.05** mg/L to about 5.0 mg/L.

As discussed above, the double-shot molded piece comprises a plating portion and a non-plating portion. Various polymers may be used for each portion and examples of suitable materials and suitable combinations of materials are provided below in Table 1. Other suitable combinations of resin in the plating portion and the non-plating portion would also be known to those skilled in the art.

**Table 1. Examples of Resin Combinations Usable in the Invention**

| | **Plating Portion** | **Non-Plating Portion** |
|---|---|---|
| 1. | ABS | ABS/PC |
| 2. | ABS | PC |
| 3. | ABS | Nylon |
| 4. | ABS | Polypropylene |
| 5. | ABS | ABS/PC/polypropylene |
| 6. | ABS | PPO |
| 7. | ABS/PC | PC |
| 8. | LCP | SPS |
| 9. | LCP, palladium filled | LCP |
| 10. | SPS. palladium filled | SPS |

| | | |
|---|---|---|
| ABS - acrylonitrile butadiene styrene PC - polycarbonate PPO - polyphenylene oxide LCP - liquid crystal polymer SPS - syndiotactic polystyrene | | |

It is generally preferred that the non-plating portion be substantially 100% resin, without any filler materials other than the catalytic poison material. This is preferred because as the parts are etched during processing, there is no filler that is removed and thus no bonding sites are created. While there may be some filled materials that can be used for the non-plating portion, these materials are of very limited offering. The filled materials can cause extensive extraneous plating across part lines as bonding sites are created by the etch chemistry. While scratches, nicks, knurls, etc. can also cause undesired plating, the inclusion of the catalytic poison in accordance with the present invention will eliminate this problem.

In order to prepare the plateable plastic portion for electroless plating thereon, the plastic part is processed through one of several typical electroless plating cycles. Various electroless plating cycles are known and may be used in the present invention. Several of these cycles are set forth below and are given by way of example and not limitation.

In one embodiment, the electroless plating cycle includes the following steps:
1) Chromic acid/sulfuric acid or an alkaline permanganate/caustic mixture;
2) Neutralization;
3) Colloidal activation;
4) Acceleration; and
5) Electroless nickel or copper plating.

Cold water rinses are typically interposed between each of the steps of the process.

In another embodiment, the electroless plating cycle includes the following steps:
1) Chromic acid/sulfuric acid;
2) Neutralization;
3) Ionic palladium activation (acid or alkaline);
4) Ionic reducer, hypophosphite or dimethylaminoborane (DMAB) mixture; and
5) Electroless nickel or copper plating.

In still another embodiment, the electroless plating cycle includes the following steps:
1) Alkaline permanganate/caustic mixture;
2) Neutralization;
3) Ionic palladium activation;
4) Ionic reducer; and
5) Electroless nickel or copper plating.

In still another embodiment, if the plastic parts include a palladium catalyst, such as palladium particles, the electroless plating cycle includes the following steps:
1) Ionic reducer; and
2) Electroless nickel or copper plating.

Finally, if a liquid crystal polymer is used for the plateable portion of the plastic part, the electroless plating cycle includes the following steps:
1) Caustic etch;
2) Acid pre-dip for neutralization;
3) Colloidal activator;
4) Acceleration; and
5) Electroless nickel or copper plating.

In the alternative, the following process may also be used for liquid crystal polymers:
1) Caustic etch;
2) Acid pre-dip for neutralization;
3) Ionic palladium activation;
4) Ionic reducer; and
5) Electroless nickel or copper plating.

Again, cold water rinses are preferably interposed between each of the steps in the electroless plating cycle.

Other electroless plating processes known in the art would also be suitable for use in the present invention.

### Example 1.

An acrylonitrile butadiene styrene terpolymer (ABS) substrate was processed through the following cycle:
1. Chromic acid/sulfuric acid solution containing 450 g/l chromic acid and 350 g/l sulfuric acid with 0.1% w/v Metex® Spray Stop-L (available from MacDermid, Inc. of Waterbury, CT), applied at a temperature of 160°F (71°C) for 8 minutes.
2. Cold water rinse (3) - for one minute.
3. Macuplex® 9339 Neutralizer (available from MacDermid, Inc. of Waterbury, CT) - 5% by volume with 3.5% by volume hydrochloric acid, applied at a temperature of 115°F (46°C) for 2 minutes.
4. Cold water rinse (2) for one minute.
5. Macuplex® D-34 Concentrated Activator (available from MacDermid, Inc. of Waterbury, CT) - 0.6% by volume with 20% by volume hydrochloric acid, applied at a temperature of 85°F (29°C) for 3 minutes.
6. Cold water rinse (2) for one minute.
7. Macuplex® 9369 Accelerator (available from MacDermid, Inc. of Waterbury, CT) - 60 g/l, applied at a temperature of 120°F (49°C) for 2 minutes. If hard water is a problem, Maccelerator® 25 (available from MacDermid, Inc. of Waterbury, CT) may be substituted for Macuplex® 9369 Accelerator.
8. Cold water rinse (2) for one minute.
9. Macuplex® J-64 EN or Ultradep® 60 electroless copper (each available from MacDermid, Inc. of Waterbury, CT)
10. Cold water rinse (3) for one minute.
11. Additional processing steps as desired.

A plating grade ABS resin (available from GE) as the plateable portion and a GE 100% polycarbonate resin with the inclusion of 0.25% by weight of tetramethylthiuram monosulfide as the catalytic poison material was processed through the above cycle. Fine part lines were notice after electroless plating, distinguishing the two plastics. No extraneous plating was noticed after QC inspection.

### Example 2.

A liquid crystal polymer (LCP) substrate was processed through the following cycle:
1. Macudizer® 9276 (available from MacDermid, Inc. of Waterbury CT) 100% by volume M-79-224, applied at a temperature of 190°F (88°C) for 6-10 minutes.
2. Cold water rinse (3) for one minute.
3. Macudizer® 9278 Glass Etch (available from MacDermid, Inc. of Waterbury, CT) 55 g/l with 7% by volume sulfuric acid, applied at a temperature of 110°F (43°C) for 5 minutes.
4. Cold water rinse (2) for one minute.
5. Acid Dip - 10% sulfuric acid, applied at a temperature of 75°F (24°C) for 1 to 2 minutes.
6. Cold water rinse (2) for one minute.
7. Conditioner 90 (available from MacDermid, Inc. of Waterbury, CT) - 10% by volume A, 5% by volume B and 2.5% by volume C, applied at 120°F (49°C) for 2 minutes.
8. Cold water rinse (2) for one minute.
9. Macuplex® D-34 Concentrate (available from MacDermid, Inc. of Waterbury, CT) - 0.8% by volume D-34 Concentrate in 20% by volume hydrochloric acid, applied at 80°F (27°C) for 2 to 4 minutes.
10. Cold water rinse (2) for one minute.
11. Ultracel® 9369 (available from MacDermid, Inc. of Waterbury, CT) - 60 g/L, applied at 120°F (49°C) for 2 to 3 minutes.
12. Cold water rinse (2) for one minute.
13. Macuplex® J-64 EN or Ultradep® 60 electroless copper (each available from MacDermid, Inc. of Waterbury, CT)
14. Cold water rinse (3) for one minute.
15. Additional processing steps as desired.

Steps 3 through 6 are only necessary if the parts to be plated contain glass as a filler and the surface appearance needs to be refined.

The above processing cycle works for various liquid crystal polymers. The processing cycle has been found to work particularly well for Vectra® LCP resins, such as Vectra® C810 resin (available from Ticona Corporation of Florence, KY).

While the invention has been described above with reference to specific embodiments thereof, it is apparent that many changes, modifications, and variations can be made without departing from the inventive concept disclosed here.

## Claims

1. A selectively plated article comprising:
a) a first plastic portion comprising a catalytic poison uniformly dispersed therein that inhibits electroless plating on the first plastic portion; and
b) a second plastic portion that is receptive to electroless plating thereon and having a layer of electroless metal plating deposited thereon;
wherein the first plastic portion is free of electroless metal plate,
**characterized in that** the catalytic poison is iodobenzoic acid.

2. The plated article according to claim 1, wherein the electroless metal plating layer is selected from the group consisting of electroless nickel and electroless copper.

3. A method of plating a plastic part, the method comprising the steps of:
a) providing a plastic part comprising:
i) a first plastic portion comprising a first plastic and a catalytic poison uniformly dispersed in the first plastic that inhibits electroless plating on the first plastic portion; and
ii) a second plastic portion comprising a second plastic that is receptive to electroless plating thereon;
b) preparing the plastic part to accept electroless plating on the second plastic portion that is receptive to electroless plating; and
c) plating the plastic part in an electroless plating bath;
whereby the first plastic portion is free of electroless plating, **characterized in that** the catalytic poison is iodobenzoic acid.

4. The method according to claim 3, wherein the electroless plating is selected from electroless copper and electroless nickel.

5. The method according to claim 3, wherein the second plastic consists of a resin selected from the group consisting of acrylonitrile butadiene styrene, acrylonitrile butadiene styrene/polycarbonate, liquid crystal polymers, palladium filled liquid crystal polymers and palladium filled syndiotactic polystyrene.

6. The method according to claim 3, wherein the first plastic portion consists of the first plastic and the catalytic poison, without any other filler materials, wherein the first plastic consists of a first resin.

7. The method according to claim 6, wherein the first resin is selected from the group consisting of acrylonitrile butadiene styrene/polycarbonate, polycarbonate, nylon, polypropylene, acrylonitrile butadiene styrene/polycarbonate/polypropylene, polyphenylene oxide, syndiotactic polystyrene and liquid crystal polymers.

8. The method according to claim 3, wherein the plastic part is a double shot molded plastic part.

9. The method according to claim 3, wherein the second plastic portion comprises a filler material selected from the group consisting of either of a sulfur species or organic iodo compounds or wherein the second plastic portion contains a palladium catalyst.

## Patentansprüche

1. Selektiv plattierter Gegenstand, umfassend:
a) einen ersten Kunststoffabschnitt, der ein katalytisches Gift umfasst, das gleichmäßig darin dispergiert ist, welches stromlose Plattierung auf dem ersten Kunststoffabschnitt inhibiert; und
b) einen zweiten Kunststoffabschnitt, der für stromlose Plattierung darauf aufnahmebereit ist, und worauf eine Schicht stromloser Metallplattierung abgeschieden ist;
wobei der erste Kunststoffabschnitt frei von stromloser Metallplatte ist,
**dadurch gekennzeichnet, dass** das katalytische Gift Iodbenzoesäure ist.

2. Plattierter Gegenstand nach Anspruch 1, wobei die stromlose Metallplattierungsschicht aus der Gruppe selektiert ist, die aus stromlosem Nickel und stromlosen Kupfer besteht.

3. Verfahren zur Plattierung eines Kunststoffteils, wobei das Verfahren folgende Schritte umfasst:
a) Bereitstellen eines Kunststoffteils, umfassend:
i) einen ersten Kunststoffabschnitt, der einen ersten Kunststoff und ein katalytisches Gift umfasst, das gleichmäßig im ersten Kunststoff dispergiert ist, der stromlose Plattierung auf dem ersten Kunststoffabschnitt inhibiert; und
ii) einen zweiten Kunststoffabschnitt, der einen zweiten Kunststoff umfasst, der für stromlose Plattierung darauf aufnahmebereit ist;
b) Vorbereiten des Kunststoffteils, um stromlose Plattierung auf dem zweiten Kunststoffabschnitt zu akzeptieren, der für stromlose Plattierung aufnahmebereit ist; und
c) Plattieren des Kunststoffteils in einem stromlosen Plattierbad;
whereby the first plastic portion is free of electroless plating,
**dadurch gekennzeichnet, dass** das katalytische Gift Iodbenzoesäure ist.

4. Verfahren nach Anspruch 3, wobei die stromlose Plattierung aus stromlosem Kupfer und stromlosem Nickel selektiert ist.

5. Verfahren nach Anspruch 3, wobei der zweite Kunststoff aus einem Harz besteht, das aus der Gruppe selektiert ist, die aus Acrylnitril-Butadien-Styrol, Acrylnitril-Butadien-Styrol/Polycarbonat, Flüssigkristallpolymeren, mit Palladium gefüllten Flüssigkristallpolymeren und mit Palladium gefülltem syndiotaktischen Polystyrol besteht.

6. Verfahren nach Anspruch 3, wobei der erste Kunststoffabschnitt aus dem ersten Kunststoff und dem katalytischen Gift, ohne irgendwelche anderen Materialien, besteht, wobei der erste Kunststoff aus einem ersten Harz besteht.

7. Verfahren nach Anspruch 6, wobei das erste Harz aus der Gruppe selektiert ist, die aus Acrylnitril-Butadien-Styrol/Polycarbonat, Polycarbonat, Nylon, Polypropylen, Acrylnitrile-Butadien-Styrol/Polycarbonat/Polypropylen, Polyphenylenoxid, syndiotaktischem Polystyrol und Flüssigkristallpolymeren besteht.

8. Verfahren nach Anspruch 3, wobei das Kunststoffteil ein Kunststoff-Formteil nach dem Zweistufenspritzgießverfahren ist.

9. Verfahren nach Anspruch 3, wobei der zweite Kunststoffabschnitt ein Füllstoffmaterial umfasst, das aus der Gruppe selektiert ist, die aus entweder einer Schwefelspezies oder organischen Iod-Verbindungen besteht, oder wobei der zweite Kunststoffabschnitt einen Palladium-Katalysator enthält.

## Revendications

1. Article plaqué de manière sélective comportant :
a) une première partie en plastique comportant un poison catalytique dispersé de manière uniforme dans celle-ci qui inhibe le placage par dépôt autocatalytique sur la première partie en plastique ; et
b) une deuxième partie en plastique qui est réceptive au placage par dépôt autocatalytique sur celle-ci et ayant une couche de placage métallique par dépôt autocatalytique déposée sur celle-ci ;
dans lequel la première partie en plastique est exempte de placage métallique par dépôt autocatalytique,
**caractérisé en ce que** le poison catalytique est de l'acide iodobenzoïque.

2. Article plaqué selon la revendication 1, dans lequel la couche de placage métallique par dépôt autocatalytique est sélectionnée dans le groupe constitué par du dépôt autocatalytique de nickel et du dépôt autocatalytique de cuivre.

3. Procédé de placage d'une pièce en plastique, le procédé comportant les étapes consistant à :
a) mettre en oeuvre une pièce en plastique comportant :
i) une première partie en plastique comportant un premier plastique et un poison catalytique dispersé de manière uniforme dans le premier plastique qui inhibe le placage par dépôt autocatalytique sur la première partie en plastique ; et
ii) une deuxième partie en plastique comportant un deuxième plastique qui est réceptif au placage par dépôt autocatalytique sur celui-ci ;
b) préparer la pièce en plastique pour accepter le placage par dépôt autocatalytique sur la deuxième partie en plastique qui est réceptive au placage par dépôt autocatalytique ; et
c) effectuer le placage de la pièce en plastique dans un bain de placage par dépôt autocatalytique ;
ce par quoi la première partie en plastique est exempte de placage par dépôt autocatalytique,
**caractérisé en ce que** le poison catalytique est de l'acide iodobenzoïque.

4. Procédé selon la revendication 3, dans lequel le placage par dépôt autocatalytique est sélectionné dans le groupe constitué par du dépôt autocatalytique de nickel et du dépôt autocatalytique de cuivre.

5. Procédé selon la revendication 3, dans lequel le deuxième plastique est constitué d'une résine sélectionnée dans le groupe constitué par de l'acrylonitrile butadiène styrène, du polycarbonate à base d'acrylonitrile butadiène styrène, des polymères à cristaux liquides, des polymères à cristaux liquides remplis de palladium et du polystyrène syndiotactique rempli de palladium.

6. Procédé selon la revendication 3, dans lequel la première partie en plastique est constituée du premier plastique et du poison catalytique, sans autres matières de remplissage, dans lequel le premier plastique est constitué d'une première résine.

7. Procédé selon la revendication 6, dans lequel la première résine est sélectionnée dans le groupe constitué par du polycarbonate à base d'acrylonitrile butadiène styrène, du polycarbonate, du nylon, du polypropylène, du polypropylène à base de polycarbonate à base d'acrylonitrile butadiène styrène, de l'oxyde de polyphénylène, du polystyrène syndiotactique et des polymères à cristaux liquides.

8. Procédé selon la revendication 3, dans lequel la pièce en plastique est une pièce en plastique moulée à injection double.

9. Procédé selon la revendication 3, dans lequel la deuxième partie en plastique comporte une matière de remplissage sélectionnée dans le groupe constitué par soit des espèces sulfureuses soit des composés iodo-organiques ou dans lequel la deuxième partie en plastique contient un catalyseur au palladium.
